# EUROPEAN PATENT SPECIFICATION

(11) **EP 3 108 283 B1**
(45) Date of publication and mention of the grant of the patent: **25.05.2022**
(21) Application number: 15716422.9
(22) Date of filing: 17.02.2015
(51) Int. Cl.: G02B 21/00, G02B 21/16, G01Q 30/02, G01N 21/64, G01Q 10/04, G01N 21/65, G02B 21/24

(54) **ATOMIC FORCE MICROSCOPE MEASURING DEVICE**
ATOMKRAFTMIKROSKOPMESSUNGSVORRICHTUNG
DISPOSITIF DE MESURE POUR MICROSCOPE À FORCE ATOMIQUE

(30) Priority: 17.02.2014 EP 14000560; 16.12.2014 EP 14004244
(43) Date of publication of application: 28.12.2016
(73) Proprietor: Universität Basel, 4003 Basel (CH); ETH Zürich, 8092 Zürich (CH)
(72) Inventor: MARTINEZ-MARTIN, David, 4051 Basel (CH); MUELLER, Daniel J., 4051 Basel (CH); MARTIN, Sascha, 4055 Basel (CH); GERBER, Christoph, 8805 Richterswil (CH)
(74) Representative: Sattler de Sousa e Brito, Clara
(86) International application number: PCT/EP2015/000349
(87) International publication number: WO 2015/120991

(56) References cited:
- WO-A1-2013/003864
- US-B1- 6 330 824
- US-B1- 6 330 824
- Alex Berquand: "Combined Optical and SPM Microscopy", , 31 January 2012 (2012-01-31), XP055196100, Retrieved from the Internet: URL:https://www.bruker.com/fileadmin/user_ upload/8-PDF-Docs/SurfaceAnalysis/AFM/Webi nars/Combined-Optical-AFM_webinar_slides_1 20118.pdf [retrieved on 2015-06-16]
- R. KASSIES ET AL: "Combined AFM and confocal fluorescence microscope for applications in bio-nanotechnology", JOURNAL OF MICROSCOPY, vol. 217, no. 1, 1 January 2005 (2005-01-01), pages 109-116, XP055042542, ISSN: 0022-2720, DOI: 10.1111/j.0022-2720.2005.01428.x
- ANDREEA TRACHE ET AL: "Atomic force-multi-optical imaging integrated microscope for monitoring molecular dynamics in live cells", JOURNAL OF BIOMEDICAL OPTICS, vol. 10, no. 6, 1 January 2005 (2005-01-01), page 064023, XP55042544, ISSN: 1083-3668, DOI: 10.1117/1.2146963
- Alex Berquand: "Combined Optical and SPM Microscopy", , 31 January 2012 (2012-01-31), XP055196100, Retrieved from the Internet: URL:https://www.bruker.com/fileadmin/user_ upload/8-PDF-Docs/SurfaceAnalysis/AFM/Webi nars/Combined-Optical-AFM_webinar_slides_1 20118.pdf [retrieved on 2015-06-16]
- ADAM HOLGER ET AL: "Photothermal excitation setup for a modified commercial atomic force microscope", REVIEW OF SCIENTIFIC INSTRUMENTS, vol. 85, no. 2, 7 February 2014 (2014-02-07), XP012181742, ISSN: 0034-6748, DOI: 10.1063/1.4864084 [retrieved on 1901-01-01]
- Ando Toshio ET AL: "High-speed atomic force microscopy for observing dynamic biomolecular processes", JOURNAL OF MOLECULAR RECOGNITION., vol. 20, no. 6, 1 January 2007 (2007-01-01), pages 448-458, XP055862221, GB ISSN: 0952-3499, DOI: 10.1002/jmr.843
- Stahl Stefan: "Konnektivität molekularer Domänen bei der kraftinduzierten Entfaltung einzelner Biomoleküle", , 24 May 2012 (2012-05-24), XP055862251, Retrieved from the Internet: URL:https://1library.net/document/yje4gw6q -konnektivitat-molekularer-domanen-kraftin duzierten-entfaltung-biomolekule-dissertat ion-fakultat.html [retrieved on 2021-11-16]

## Description

The invention relates to an atomic force microscope measuring device comprising a micro-cantilever and an intensity modulated light source exciting the cantilever.

The invention proposed herein is based on Atomic Force Microscopy technology. It allows to determine topography, physical, chemical and biological properties of biological systems such as single cells, tissues, single molecules, protein crystal structures, over time and in physiological relevant environment. In addition this device can be applied to characterize any other type of material and it is able to work in other environments such as air ambient conditions or vacuum. Furthermore our device is useful to study cell-cell or cell-tissue interactions. This invention has been developed to be fully compatible with optical techniques as fluorescence, Differential Interference Contrast (DIC), phase contrast, Raman spectroscopy and related techniques.

The atomic force microscopy (AFM) has not stopped developing since its invention. In US6330824 B1 new imaging method for AFM is described. As a novelty this method excites the cantilever probe of the AFM using an intensity modulated laser.

There are different architectures to build an AFM based on photothermal excitation. In many cases, an optical microscope is used to focus the intensity modulated laser on the cantilever. This microscope can be simultaneously used to focus a second laser on the cantilever in order to read out its movement as. Of course, the optical microscope used in this configuration enables to see the cantilever and therefore to position and focus the laser or lasers on the cantilever. However, this configuration does not allow to use the optical microscope to obtain any other type of information from the sample such as Differential Interference Contrast (DIC), epifluorescence or similar techniques.

Other architectures use an additional set of optical elements to focus the laser for the photothermal excitation allowing to use a top-view optical microscope [5] with many restrictions. The optical microscope in this configuration is mainly used to locate properly the laser on the cantilever. However, as in the previous cases, this type of architecture is not compatible with important optical techniques for cell biology as for instance DIC, fluorescence.

Atomic Force Microscopy (AFM) has reached an exciting stage that allows studying topography, physical, chemical and biological properties and interactions of samples with piconewton sensitivity and subnanometer resolution. These capabilities together with its ability to work in liquids make AFM a powerful multifunctional toolbox to study a big variety of biological systems, ranging from single molecules to single cells or tissues, in or close to their physiological environment.

In the Journal of Microscopy, Vol 217. Pt.1 January 2005, pp. 109-116, R. Kassies et al. disclose a combined AFM and confocal fluorescence microscope for applications in bionanotechnology. In the Journal of Biomedical Optics 10(6), 064023 (November/Decemer 2005) A. Trache et al. disclose an atomic force-multi-optical imaging integrated microscope for monitoring molecular dynamics in live cells. WO 2013/003864 A1 discloses an atomic force microscope based apparatus and method for detecting Raman effect on a sample of interest. In Applied Physics Letters 93, 193101 (2008), N. P. Malcom et al. disclose a Simulation of a plasmonic tip-terminated scanning nanowire waveguide tor molecular imaging. WO 96/05531 relates to near-field optical microscopy in which a sample undergoing study is irradiated with light and the reflection/transmission or absorption characteristics of the sample are analyzed so that an image of the sample is generated. A setup is disclosed, having a microscope measuring device comprising a cantilever for probing a sample, wherein the measuring device comprises an optical microscope and an illumination source, wherein the illumination source is located at the opposite side of the cantilever with respect to the optical microscope, wherein the cantilever is transparent for a wavelength of the visual spectrum, such that the light generated by the illumination source can go through the sample and be collected by the optical microscope. Another embodiment discloses the combination with an atomic force microscope.

Despite of AFM is able to extract important information when working in liquids, its performance is severely hampered due to undesired hydrodynamic effects that can perturb the cantilever, limiting importantly the conditions that can be applied in order to extract quantitative information from samples. The origin of this limitation is related with the fact that many operation AFM modes require to excite the cantilever, which in the vast majority of the instruments is done by using a dither piezo. This excitation method is very easy to implement and requires a very small cost. In addition it works very efficiently in vacuum or air ambient conditions. However its performance in liquids drops dramatically since it does not shake only the cantilever but the liquid where the sample and cantilever are submerged in, which disturbs significantly the movement of the cantilever making very difficult its interpretation and hence extracting quantitative information from the sample.

The previous limitations can be overcome by exciting the cantilever using an intensity modulated laser (photothermal excitation). This laser is generally focused at the base of the cantilever and produces a very localized heating that stresses the cantilever surface resulting in a cantilever bending. Since just the cantilever is excited, its movement follows an expected behavior which is very close to an ideal driven and damped harmonic oscillator. Nevertheless, AFM's based on this excitation method has not been developed so far to be compatible with optical techniques such as DIC, fluorescence and other related techniques, lacking the possibility of addressing important questions that required both types of information to be acquired.

It is an object of the invention to improve these known devices. The subject-matter of the invention is defined in the claims.

According to a first aspect of the invention, a solution to this technical problem is solved by providing an atomic force microscope measuring device according to claim 1. The light source can be any source of electromagnetic radiation with a wavelength preferably within the range of 350 nm to 750 nm. The electromagnetic radiation can be coherent or non-coherent, monochromatic or non-monocromatic. In particular the intensity modulated light source can be a laser.

Due to the importance of being able to simultaneously track the topography and physical, chemical and biological properties of biological systems together with its functional state, the AFM is able to work based on photothermal excitation but in addition is fully compatible with modern optical microscopy techniques such as fluorescence, fluorescence energy transfer (FRET), confocal microscopy, DIC and/or phase contrast microscopy, and in general all those based on an inverted microscope. Therefore the device enables to extract and correlate the most accurate information obtained by this combination of tools. Although there are Atomic Force Microscopes (AFM) that oscillate the cantilever by photothermal excitation, those systems are not compatible with modern optical techniques such as DIC, fluorescence microscopy, etc. A typical reason is that, in general, those AFM systems use an optical microscope to focus an intensity modulated laser on the cantilever in order to excite (oscillate) the cantilever, which eliminates the possibility of using that microscope for fluorescence imaging. On the contrary, the device described herein is designed in such a way that the intensity modulated laser can be positioned and focused on the cantilever with a special set of optical elements and nanopositioners. The optical pathway allows optical access from the top and bottom of the device without compromising the cantilever excitation mechanism. Additionally the reverse is also true, meaning that the cantilever excitation do not compromise the acquisition of information by modern optical techniques, being both types of systems able to work simultaneously. This fact together with the transparency of the cantilever, cantilever holder and sample holder are designed to be fully compatible with modern optical techniques. It is important to note that the device described herein shares some features with systems used for near field optics, however there are major differences. For instance, some systems used for near field optics, have a cantilever and attached to it a waveguide. A laser is focused on the waveguide which has to be very close to a sample (typically several nanometers or tens of nanometers) containing metals in order to excite plasmons. The device described herein does not have a waveguide attached to the cantilever. In addition, the device described herein does not use a laser to induce effects of near field optics such as the excitation of plasmons but to deflect the cantilever over time. Furthermore, the device described herein is able to extract the information from the sample without the need of containing metals. Moreover, the device utilizes a second laser which is located near the free end of the cantilever in order to read out the deflection of the cantilever. However, this second laser is not compulsory and other systems can be applied such as piezoelectric cantilevers, piezoresistive cantilevers, Doppler interferometers, etc.

According to the invention, the cantilever is transparent for a wavelength of the visual spectrum, such that the light generated by the illumination source can go through the sample and be collected by the optical microscope. The cantilever can be partially or totally transparent for the wavelength of the visual spectrum. This allows for a combination with important optical techniques in cell biology.

At least the part of the cantilever that is close to its free end is partially transparent for at least some wave length of the visual spectrum and it is not smaller than 10 µm × 10 µm. This window of transparency or partial transparency for at least some wavelength of the visual spectrum is a requirement for the device to be compatible with techniques such as DIC (Differential Interference Contrast) or equivalents techniques, which allow obtaining crucial information about the morphology of the biological sample even when the sample is being probed by the cantilever or when there is a biological system sitting on or close to the free end of the cantilever. These types of techniques, require a special type of illumination, which has to go through the sample and be collected using a special optical microscope located opposite to the illumination source. In addition to the DIC information, the objective allows our device to get fluorescence information from the sample.

Preferably the cantilever has a length in the range of 10 µm to 1000 µm and/or a resonance frequency for the fundamental mode in the range of 1Hz to 10 MHz in air ambient conditions. Finally the cantilever preferably has an oscillation amplitude when excited at the fundamental resonance in the range of 0,01 nm to 500 nm, preferably smaller than 100 nm. To optimize the measuring device it is possible to choose or adapt a cantilever by adapting the cantilever dimensions for different applications.

Preferably the wave length of the exciting light is in a range from 350 nm to 750 nm, it may be between 350 nm and 550 nm. Specifically a wavelength of 405 nm may be used which has the additional advantage that it is far enough from many of the wave lengths used in fluorescence microscopy. However, depending on the cantilever material other wavelengths may be used as well. In particular, the wavelength of the exciting light is chosen such that it is strongly absorbed by the cantilever.

Advantageously the position, diameter and focus of the exciting light spot on the cantilever may be adjusted and may be located at the base of the cantilever or close to the base of the cantilever. This maximizes the excitation efficiency. The exciting light spot may be smaller than 100 µm, preferably smaller than 50 µmin diameter, preferably smaller than 10 µm in diameter. This size allows exciting the cantilever with high efficiency and at the same time allows having the laser far from the biological system to avoid interactions with the sample.

There are two ways to include the scanner or scanners into the system:
1.-The scanner holds and moves the cantilever or cantilever holder with respect the sample. In addition, if necessary, the scanner holds and moves other elements of the device to ensure that the excitation of the cantilever and the read out of its movement are properly done. Equivalently and for simplicity, the scanner can hold and move the whole device with respect the sample. We refer to this system as head scanner.
2.-The scanner holds and moves the sample with respect to the cantilever. We refer to this system as sample scanner.

Supplementary, any combination of the two previous strategies can be used in order to achieve a specific performance of the instrument.

The invention will be described in more detail hereinafter with reference to an exemplary embodiment. In the drawing,
- Figure 1: shows a schematic sketch of a head scanner,
- Figure 2: shows schematic three-dimensional cross sectional drawing of a head scanner,
- Figure 3: shows schematic three-dimensional top view drawing of a head scanner,
- Figure 4: shows a sketch of a sample scanner,
- Figure 5: shows schematic three-dimensional cross sectional drawing of a sample scanner,
- Figure 6: shows schematic three-dimensional top view drawing of a sample scanner and
- Figure 7: shows schematic two-dimensional top view drawing of a head and sample scanner (since they are identical in this perspective) with arrows that indicate the directions of movement.

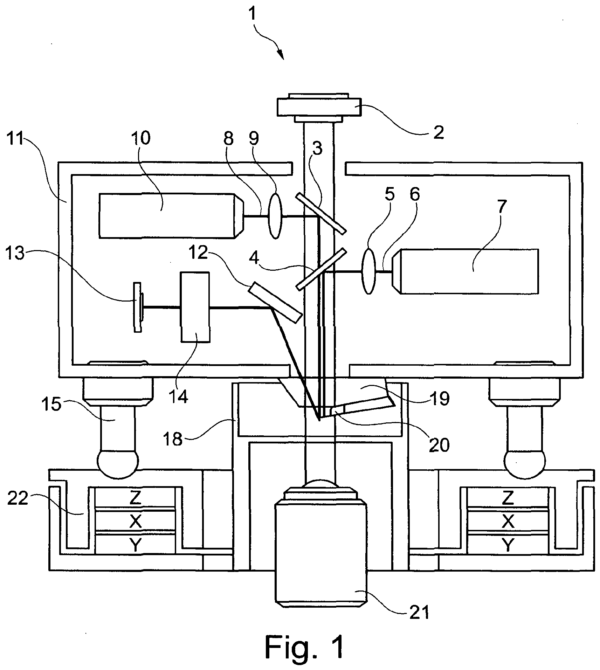

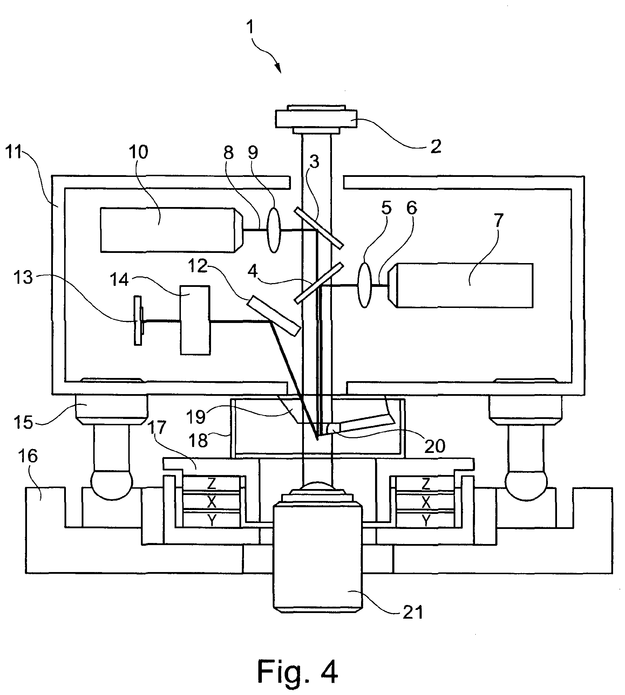

As can be seen the Figures 1 and 4, a 405 nm laser (7) is focused on the base of a microcantilever using a set of optical elements represented as (5) and the dichroic mirror (4) in order to photothermally excite the cantilever. The movement of the cantilever is detected using a beam deflection scheme but other methods can be also applied. The laser beam (8) is focused at the end of the cantilever using a set of optical elements represented as (9) and the dichroic mirror (3). The laser beam (8) reflects partially on the cantilever (20) and hits a gold mirror (12) that addresses the beam into a four quadrants photodetector (13) to be analyzed. Thanks to the optical properties of the dichroic mirrors (3) and (4) together with the cantilever holder (19), the cantilever itself which is totally or partially transparent and the sample holder (18), special light generated in (2) can go through the sample and be collected with an inverted microscope (21) for DIC imaging or similar techniques. In addition, the microscope (21) allows to illuminate the sample with suitable light to excite fluorescent and collect back the fluorescent emitted light from the sample according to an inverted microscope set-up. An XYZ scanner enables to locate the cantilever in different positions of the sample by either moving the sample holder (18) or the box (11) with subnanometer resolution. The actuators (15) carry out a coarse vertical movement to approach or withdraw the cantilever to the sample. In addition these actuators can tilt the box (11) with respect to the sample holder (18).

In order to ensure a very high stability of the excitation of the cantilever, the exciting laser diode is kept at a fixed temperature by using a peltier element. This thermoelectric system ensures that wavelength and intensity of the laser will not shift due to temperature changes. By modulating the current that feeds the diode, the intensity of the laser can be modulated at a certain frequency. However other ways to modulate the light intensity can be applied as for instance by using acousto-optical or electro-optical modulators. The light emitted by the laser diode is then introduced into an optical fiber in order to reach an optical collimator which is located in the head of the instrument. The optical collimator is focusable and allows to get a laser beam with parallel rays. However, in order to modify the laser waist (minimum spot diameter) the collimator can be set to produce non parallel rays as well. At the end of the collimator and attached to it there is a micro focus optics which ensures that the laser light will be focus at a certain distance, usually the distance or close to the distance the cantilever is at.

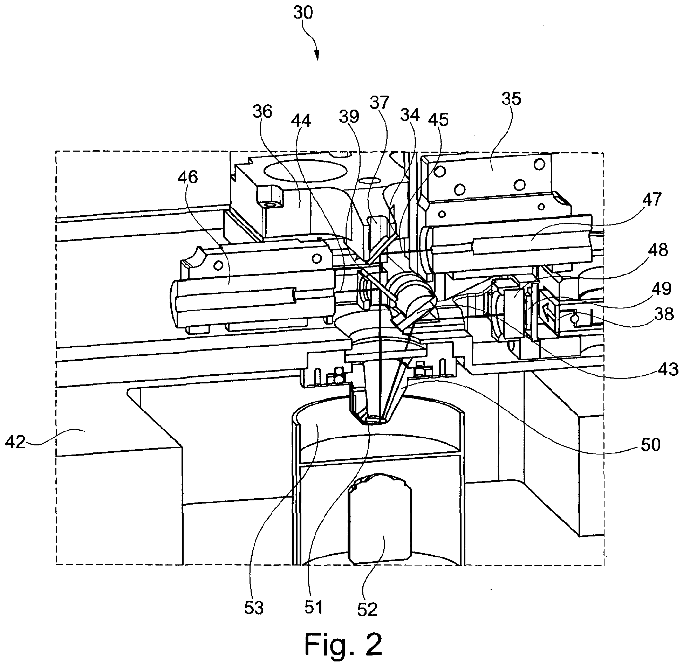

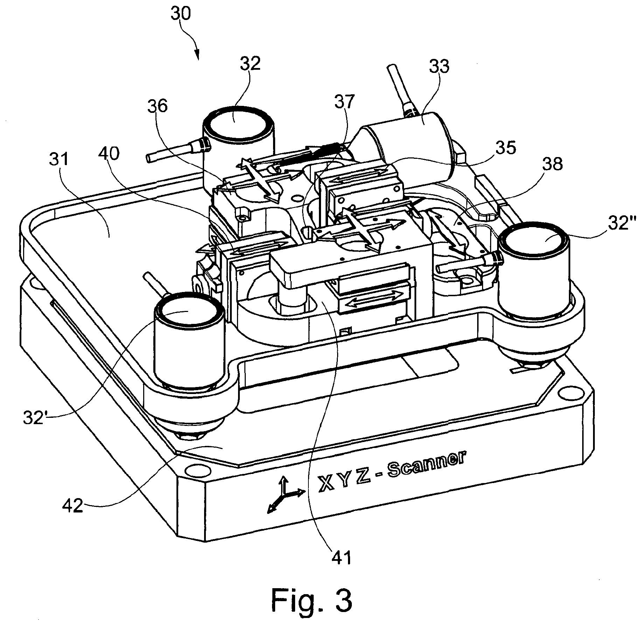

The end of the optical fiber, together with the collimator and the micro focus optics (46 in figure 2) are mounted on a nanopositioner system (40 in figure 3) which is able to travel several millimeters with nanometric resolution. This nanopositioner system allows to modify the distance between the cantilever (51 in figure 2) and the optical system (46). Doing so, the system has a very precise and comfortable way to modify the laser spot size on the cantilever, just by changing the position where the beam waist is. This adjustment can be very important in order to optimize the cantilever excitation for the following reasons:
1.-It enables to find the optimum laser spot diameter to excite the cantilever using the minimum power. This fact, for instance, can be very important when a biological sample is sitting close the end of the cantilever, since that part of the cantilever might be required to be at a physiological temperature and hence to excite the cantilever with very low power can be a need.
2. It brings the possibility of modifying the length and/or material of the cantilever holder (50 in figure 2) making the system very versatile to work using for instance petri dishes of different heights or dealing with a special sample holder in order to keep the sample under incubation conditions by using for instance air with 5% CO2 and high humidity.

In addition the nanopositioner system (40 in figure 3) is held by a set of nanopositioners (41 in figure 3) which enable to move in XY directions the optical system (46) in order to ensure that the laser hits the cantilever on the desired location. This set of nanopositioners hold as well a dichroic mirror (39 in figure 2) which deviates in 90 degrees the laser light coming from the optical system (46) but not other wavelengths of the visual spectrum. This way, the laser (44) can hit on the cantilever with almost normal incidence and simultaneously other types of illumination such as DIC, phase contrast or related techniques can be utilized from the top.

A laser diode can be used in the device as a source of light to excite the cantilever, however the use of laser light is not a requirement and other types of light can be used.

The advantage of our invention over the state of the art is that our device allows using a photothermal based AFM in fully combination with modern optical techniques such as DIC, fluorescence, FRET, confocal microscopy and in general all those based on an inverted microscope.

Reference numbers for Figure 1 and 4:
- 1.: Atomic force microscope measuring device
- 2.: DIC, phase contrast or other type of illumination to characterize the morphology of biological samples
- 3.: Dichroic mirror that reflects the 850 nm wavelength allowing other wavelengths in the visual spectrum to go through
- 4.: Dichroic mirror that reflects the 405 nm wavelength allowing other wavelengths in the visual spectrum and the 850 nm wavelength to go through
- 5.: Optical system to correct and focus the 405 nm laser beam (6)
- 6.: 405 nm laser beam
- 7.: 405 nm laser diode and optical fiber to drive the laser into the optical system (5)
- 8.: 850 nm laser beam
- 9.: Optical system to correct and focus the 850 nm laser (8)
- 10.: 850 nm laser diode and optical fiber to drive the laser into the optical system (9)
- 11.: Base of the box to hold the apparatus
- 12.: Mirror that reflects the 850 nm laser (8) to hit the photodiode (13)
- 13.: Four quadrant photodiode
- 14.: Band-pass filter center at 850 nm. It allows the 850 nm laser beam to reach the photodiode (13) but blocks other wavelengths
- 15.: Actuators to move the box and hence the cantilever along the vertical direction. These actuators for instance allow approaching and withdrawing the cantilever to the sample
- 16.: Platform that holds the box (11). The platform contains XY positioner that allow to do a coarse movement of the box (11) with respect to the sample holder (18)
- 17.: Hollow scanner system that holds the sample holder (18). It allows the move the sample holder (18) in three orthogonal directions (X, Y and Z) with respect to the box (11). The system contains in addition XY positioners that allow to do a coarse movement of the sample holder (18) with respect to the box (11)
- 18.: Sample holder
- 19.: Cantilever holder
- 20.: Cantilever chip
- 21.: Inverted microscope. It is compatible with modern optical techniques such as fluorescence, DIC, phase contrast, confocal microscopy, FRET, raman spectroscopy
- 22.: Hollow scanner system that allows to move the box (11) with respect to the sample holder (18) in three orthogonal directions (X, Y and Z). In addition the scanner contains two positioners to do a coarse movement of the box (11) with respect to the sample holder (18)

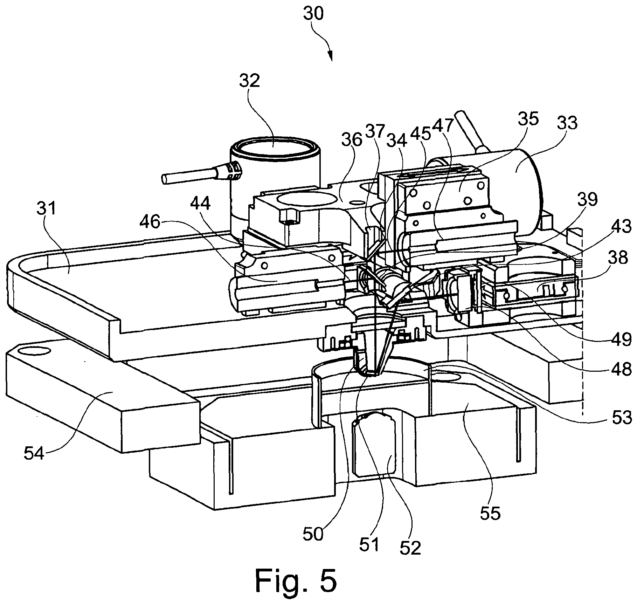

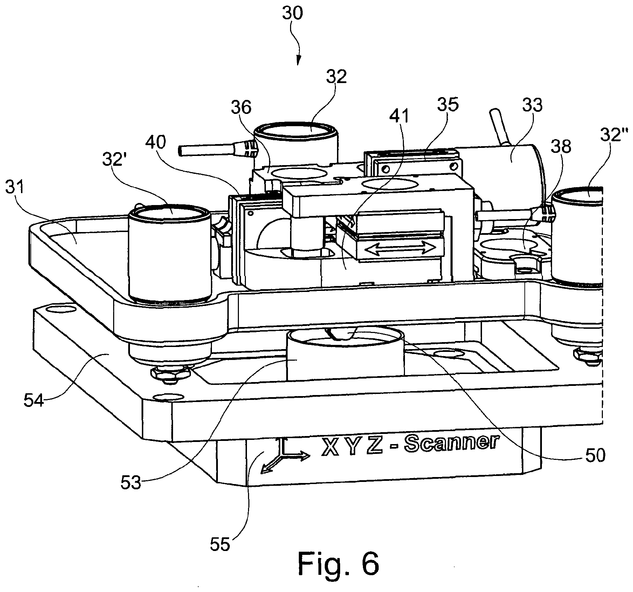

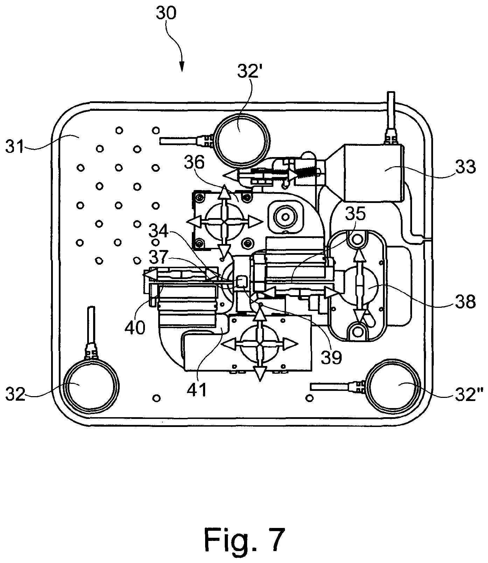

Reference numbers for Figures 2 to 3 and 5 to 7:
- 30.: Atomic force microscope measuring device
- 31.: Base of the box to hold the apparatus
- 32.: Actuators to move the box and hence the cantilever along the vertical direction. These actuators for instance allow approaching and withdrawing the cantilever to the sample
- 33.: Actuator that moves the mirror (43) by spinning the mirror's holder. This actuator allows addressing (reflecting) the 850 nm laser (45) on the photodiode (49)
- 34.: Dichroic mirror that reflects the 850 nm wavelength allowing other wavelengths in the visual spectrum to go through
- 35.: Positioner system that holds the optical system to focus the 850 nm laser (45). This system can move as shown by the arrows, which for instance allows modifying the laser spot diameter on the cantilever (51)
- 36.: Positioner system that holds the positioner system (35) and the dichroic mirror (34). The system can move as shown by the arrows, which allows positioning the 850 nm laser beam (45) to hit on a certain place as for instance the cantilever (51)
- 37.: Window to allow DIC, phase contrast or other illumination types
- 38.: Positioner system that allows moving the photodiode as shown by the arrows. This system for instance can be used in combination with (33) to make the 850 nm laser hit on a certain part of the photodiode
- 39.: Dichroic mirror that reflects the 405 nm wavelength allowing other wavelengths in the visual spectrum and the 850 nm wavelength to go through
- 40.: Positioner system that holds the optical system to focus the 405 nm laser (44). This system can move as shown by the arrows, which for instance allows modifying the laser spot diameter on the cantilever (51)
- 41.: Positioner system that holds the positioner system (40) and the dichroic mirror (39). The system can move as shown by the arrows, which allows positioning the 405 nm laser beam (44) to hit on a certain place as for instance the cantilever (51)
- 42.: Hollow scanner system that allows to move the box (31) with respect to the sample holder (53) in three orthogonal directions (X, Y and Z). In addition the scanner contains XY positioners to do a coarse movement of the box (31) with respect to the sample holder (53)
- 43.: Mirror that reflects the 850 nm laser (45) to hit the photodiode (49)
- 44.: 405 nm laser beam
- 45.: 850 nm laser beam
- 46.: Optical system to correct and focus the 405 nm laser (44)
- 47.: Optical system to correct and focus the 850 nm laser (45)
- 48.: Band-pass filter center at 850 nm. It allows the 850 nm laser beam to reach the photodiode (49) but blocks other wavelengths
- 49.: Four quadrant photodiode
- 50.: Cantilever holder
- 51.: Cantilever chip
- 52.: Inverted microscope. It is compatible with modern optical techniques such as fluorescence, DIC, phase contrast, confocal microscopy, FRET, Raman spectroscopy
- 53.: Sample holder. It contains XY positioners to do a coarse movement of the sample holder (53) with respect to the box (31)
- 54.: Platform where the box (31) is sitting. The platform contains XY positioner for a coarse movement of the box (31) with respect to the sample holder (53)
- 55.: Hollow scanner system that holds the sample holder (53). It allows to move and scan the sample holder (53) with respect to the box (31) in three orthogonal directions (XYZ). In addition contains XY positioners for a coarse movement of the sample holder (53) with respect to the box (31)

## Claims

1. Atomic force microscope measuring device (1, 30) comprising a micro-cantilever (20, 51) for probing a sample, wherein the measuring device comprises an optical microscope (21, 52), preferably a fluorescence microscope, a confocal microscope, a fluorescence energy transfer (FRET) microscope, a DIC and/or phase contrast microscope, all of those preferably construed as an inverted microscope; and an illumination source (2), wherein the illumination source is located at the opposite side of the cantilever (20, 51) with respect to the optical microscope (21, 52), wherein the measuring device comprises an intensity modulated light source (7) exciting the cantilever (20, 51), wherein the cantilever is transparent for a wavelength of the visual spectrum, such that the light generated by the illumination source (2) can go through the sample and be collected by the optical microscope (21, 52).

2. Measuring device (1, 30) according to claim 1, wherein the cantilever (20, 51) has a length in the range of 10 µm to 1000 µm, preferably in the size of 10 µm to 500 µm and/or a fundamental resonance frequency in a range of 1 Hz to 10 MHz, preferably in the range of 1 kHz to 2000 kHz, when immersed in water and/ or a oscillation amplitude when excited at resonance in the range of 0,01 nm to 500 nm, preferably smaller than 100 nm and/or the exciting light has a wavelength in the range of 350 nm to 750 nm, preferably in a range of 350 nm to 450 nm.

3. Measuring device (1, 30) according to one of the claims 1 or 2, wherein the exciting light spot is focused on the base of the cantilever (20, 51).

4. Measuring device (1, 30) according to one of the preceding claims, wherein the exciting light spot is smaller than 100 µm, preferably smaller than 50 µm in diameter, preferably smaller than 10 µm in diameter.

## Patentansprüche

1. Rasterkraftmikroskop-Messvorrichtung (1, 30), umfassend einen Mikro-Cantilever (20, 51) zum Prüfen einer Probe, wobei die Messvorrichtung ein optisches Mikroskop (21, 52), vorzugsweise ein Fluoreszenzmikroskop, ein konfokales Mikroskop, ein Fluoreszenz-Energietransfer-Mikroskop (FRET-Mikroskop), ein DIC- und/oder Phasenkontrastmikroskop, die alle vorzugsweise als inverses Mikroskop ausgelegt sind, umfasst; und eine Beleuchtungsquelle (2), wobei die Beleuchtungsquelle auf der gegenüberliegenden Seite des Cantilevers (20, 51) in Bezug auf das optische Mikroskop (21, 52) angeordnet ist, wobei die Messvorrichtung eine intensitätsmodulierte Lichtquelle (7) umfasst, die den Cantilever (20, 51) erregt, wobei der Cantilever für eine Wellenlänge des visuellen Spektrums transparent ist, sodass das von der Beleuchtungsquelle (2) erzeugte Licht durch die Probe hindurchgehen und von dem optischen Mikroskop (21, 52) gesammelt werden kann.

2. Messvorrichtung (1, 30) nach Anspruch 1, wobei der Cantilever (20, 51) eine Länge in dem Bereich von 10 µm bis 1000 µm, vorzugsweise in der Größe von 10 µm bis 500 µm, und/oder eine Grundresonanzfrequenz in dem Bereich von 1 Hz bis 10 MHz, vorzugsweise in dem Bereich von 1 kHz bis 2000 kHz, bei Eintauchen in Wasser und/oder eine Schwingungsamplitude bei Erregung zur Resonanz in dem Bereich von 0,01 nm bis 500 nm, vorzugsweise kleiner als 100 nm, aufweist und/oder das erregende Licht eine Wellenlänge in dem Bereich von 350 nm bis 750 nm, vorzugsweise im Bereich von 350 nm bis 450 nm, aufweist.

3. Messvorrichtung (1, 30) nach einem der Ansprüche 1 oder 2, wobei der erregende Lichtpunkt auf die Basis des Cantilever (20, 51) fokussiert ist.

4. Messvorrichtung (1, 30) nach einem der vorhergehenden Ansprüche, wobei der erregende Lichtpunkt kleiner als 100 µm, vorzugsweise kleiner als 50 µm im Durchmesser, vorzugsweise kleiner als 10 µm im Durchmesser ist.

## Revendications

1. Dispositif de mesure pour microscope à force atomique (1, 30) comprenant un microlevier (20, 51) destiné à sonder un échantillon, ledit dispositif de mesure comprenant un microscope optique (21, 52), de préférence un microscope à fluorescence, un microscope confocal, un microscope de transfert d'énergie de fluorescence (FRET), un microscope DIC et/ou à contraste de phase, tous parmi ceux-ci étant de préférence considérés comme un microscope inversé ; et une source d'éclairage (2), ladite source d'éclairage étant située sur le côté opposé du microlevier (20, 51) par rapport au microscope optique (21, 52), ledit dispositif de mesure comprenant une source de lumière à modulation d'intensité (7) excitant le microlevier (20, 51), ledit microlevier étant transparent pour une longueur d'onde du spectre visuel, de sorte que la lumière générée par la source d'éclairage (2) puisse traverser l'échantillon et être collectée par le microscope optique (21, 52).

2. Dispositif de mesure (1, 30) selon la revendication 1, ledit microlevier (20, 51) possédant une longueur dans la plage allant de 10 µm à 1000 µm de préférence dans la taille allant de 10 µm à 500 µm et/ou une fréquence de résonance fondamentale comprise dans la plage allant de 1 Hz à 10 MHz, de préférence dans la plage allant de 1 kHz à 2000 kHz, lorsqu'il est immergé dans l'eau et/ou une amplitude d'oscillation lorsqu'il est excité à la résonance dans la plage allant de 0,01 nm à 500 nm, de préférence inférieure à 100 nm et/ou la lumière d'excitation possédant une longueur d'onde comprise dans la plage allant de 350 nm à 750 nm, de préférence dans la plage allant de 350 nm à 450 nm.

3. Dispositif de mesure (1, 30) selon l'une des revendications 1 ou 2, ledit point lumineux d'excitation étant focalisé sur la base du microlevier (20, 51).

4. Dispositif de mesure (1, 30) selon l'une des revendications précédentes, ledit point lumineux d'excitation étant inférieur à 100 µm, de préférence inférieur à 50 µm de diamètre, de préférence inférieur à 10 µm de diamètre.
